# EUROPEAN PATENT APPLICATION

(11) **EP 1 666 858 A1**
(43) Date of publication of application: **07.06.2006**
(21) Application number: 04746415.1
(22) Date of filing: 18.06.2004
(51) Int. Cl.: G01L 1/16, G01R 31/02

(54) **PRESSURE-SENSITIVE SENSOR**

(30) Priority: 02.07.2003 JP 2003190128
(71) Applicant: MATSUSHITA ELECTRIC INDUSTRIAL CO., LTD., Kadoma-shi, Osaka 571-8501 (JP)
(72) Inventor: OGINO, Hiroyuki, (JP); UEDA, Shigeki, (JP); KASAI, Isao, (JP); ITOU, Shuji, (JP); SUGIMORI, Tooru, (JP)
(74) Representative: Grünecker, Kinkeldey, Stockmair & Schwanhäusser Anwaltssozietät
(86) International application number: PCT/JP2004/008946
(87) International publication number: WO 2005/003707

(57) **Abstract**

A plurality of lead-out wires 10 and 11 provided with insulating coating are stacked in a pressure sensitive sensor 1 and are molded in the shape of a cable, and at a distal end portion S the lead-out wire 11 is connected to a central electrode 2 and the lead-out wire 10 to an outer electrode 4. Consequently, if the pressure sensitive sensor 1 is connected to an external circuit 12, and a third resistor 15 is connected between the lead-out wire 10 and the lead-out wire 11 in the external circuit 12, a circuit is formed which is equivalent to a circuit for detecting a disconnection and a short circuit in a conventional pressure sensitive sensor, making it possible detect a disconnection and a short circuit of each electrode. Further, the construction of the leading end portion becomes simple, and a nonsensitive area can also be reduced, so that the detection performance improves.

## Description

### <Technical Field>

The present invention relates to a cable-like pressure sensitive sensor, and more particularly to a configuration for detecting a disconnection thereof.

### <Background Art>

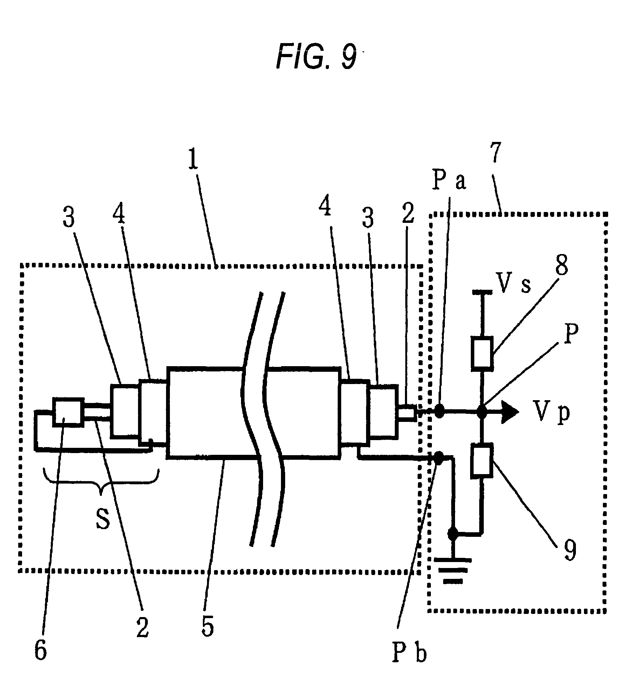

Referring to Fig. 9, a description will be given of a conventional pressure sensitive sensor. Fig. 9 is a schematic diagram of a pressure sensitive sensor 1. As shown in Fig. 9, the pressure sensitive sensor 1 is a piezoelectric sensor in which a central electrode 2, a piezoelectric material layer 3 serving as a pressure sensitive layer, an outer electrode 4, and a cladding layer 5 are formed in the shape of a coaxial cable.

Generally, in the improvement of the reliability and productivity of such a piezoelectric sensor molded in the form of a coaxial cable, in a case where consideration is given to the ease of the process of inspection of a disconnection, a short circuit, and the like of the piezoelectric sensor and the inspection and confirmation of a disconnection, a short circuit, and the like when secondary processing is performed by using the cable-like pressure sensitive sensor, the inspection operation at both ends of the cable involved much time and trouble.

Accordingly, there is a method in which continuity between both ends of the central electrode 2 or the outer electrode 4 is measured by a tester or the like to detect a disconnection or a short circuit of the pressure sensitive sensor 1. However, since it is not practical to use the tester on each occasion for the measurement of continuity, a configuration is provided in which, as shown in Fig. 9, a sensor-side resistor 6 for detecting a disconnection and a short circuit is connected between the central electrode 2 and the outer electrode 4 at a distal end portion S, and a bias voltage is applied from an external circuit 7 side connected to the pressure sensitive sensor 1, as will be described later, to thereby detect a disconnection or a short circuit.

Here, reference numeral 8 denotes a circuit-side resistor for detecting a disconnection and a short circuit, and reference numeral 9 denotes a signal leading-out resistor for leading out a signal from the pressure sensitive sensor 1. It is assumed that resistance values of the circuit-side resistor 8, the signal leading-out resistor 9, and the sensor-side resistor 6 are R1, R2, and R3, respectively, that the voltage at a point P is Vp, and that the supply voltage is Vs. Resistance values of several megaohms to several dozen megaohms are generally used as R1, R2, and R3.

By virtue of this configuration, in a case where the electrodes of the pressure sensitive sensor 1 are normal, Vp assumes a divided voltage value of R1 and the parallel resistance of R2 and R3 with respect to Vs. Here, since the resistance value of the piezoelectric material layer 3 is generally several hundred megaohms or more, the resistance value of the piezoelectric material layer 3 practically does not contribute to the parallel resistance value of R2 and R3, so that this resistance value is assumed to be negligible in the calculation of the aforementioned divided voltage value. Next, if at least one of the central electrode 2 and the outer electrode 4 of the pressure sensitive sensor 1 becomes disconnected, a point Pa or a point Pb becomes equivalently open, so that Vp assumes a divided voltage value of R1 and R2. If the central electrode 2 and the outer electrode 4 are short-circuited, the point Pa and the point Pb become equivalently short-circuited, so that Vp becomes equal to the circuit ground voltage. Thus, an abnormality such as a disconnection or a short circuit of the electrode of the pressure sensitive sensor 1 is detected on the basis of the value of Vp (refer to paten document 1).

### [Patent document 1]

### JP-A-2003-106048 (pp. 4 to 5, Fig. 5)

However, with the above-described conventional sensor, since the sensor-side resistor 6 is connected to the distal end portion S, there have been problems in that the configuration is complex, and there is a nonsensitive area by the portion of the dimension of the sensor-side resistor 6.

In addition, in the case where the pressure sensitive sensor 1 is used, if an insertion hole is provided in an elastic material constituted by a rubber member or the like, and the pressure sensitive sensor 1 is used by being inserted into the insertion hole, the elastic material is elastically deformed, and the pressure sensitive sensor 1 becomes deformable, so that the sensitivity of the pressure sensitive sensor 1 improves. However, there has been a problem in that since the above-described conventional pressure sensitive sensor 1 has the sensor-side resistor 6, the outside diameter of the end portion S becomes greater than the outside diameter of the pressure sensitive sensor 1, so that it is difficult to insert the pressure sensitive sensor 1 into the insertion hole.

### <Disclosure of the Invention>

The present invention overcomes such conventional problems, and its object is to provide a pressure sensitive sensor which is capable of reducing the nonsensitive area, of making the outside diameter of the distal end portion small, and of detecting a disconnection and a short circuit of the pressure sensitive sensor.

To overcome the above-described problems, in the invention, a central electrode, a pressure sensitive layer, an outer electrode, and a plurality of lead-out wires provided with insulating coating are laminated and formed in a shape of a cable, wherein at a distal end portion at least one of the lead-out wires is connected to the central electrode, and a remaining lead-out wire is connected to the outer electrode.

Consequently, if, for example, the pressure sensitive sensor is connected to an external circuit, and a resistor is connected between the lead-out wire conducting with the central electrode and the lead-out wire conducting with the outer electrode in the external circuit instead of providing the resistor at the distal end portion of the pressure sensitive sensor in the conventional manner, a circuit is formed which is equivalent to the circuit for detecting a disconnection and a short circuit in a conventional pressure sensitive sensor, making it possible detect a disconnection and a short circuit of each electrode. In addition, since the resistor is not provided at the distal end portion in the conventional manner, the construction of the leading end portion becomes simple, a nonsensitive area can also be reduced, and the outside diameter of the distal end portion can be made small.

In the invention according to claim 1 for overcoming the above-described problems, a central electrode, a pressure sensitive layer, an outer electrode, and a plurality of lead-out wires provided with insulating coating are laminated and formed in a shape of a cable, wherein at a distal end portion at least one of the lead-out wires is connected to the central electrode, and a remaining lead-out wire is connected to the outer electrode. Consequently, if, for example, the pressure sensitive sensor is connected to an external circuit, and a resistor is connected between the lead-out wire conducting with the central electrode and the lead-out wire conducting with the outer electrode in the external circuit instead of providing the resistor at the distal end portion of the pressure sensitive sensor in the conventional manner, a circuit is formed which is equivalent to the circuit for detecting a disconnection and a short circuit in the conventional pressure sensitive sensor, making it possible detect a disconnection and a short circuit of each electrode. In addition, since the resistor is not provided at the distal end portion in the conventional manner, the construction of the leading end portion becomes simple, and a nonsensitive area can also be reduced, so that the detection performance improves. Further, since the outside diameter of the distal end portion can be made small, it becomes easy to insert the pressure sensitive sensor when the pressure sensitive sensor is inserted into an elastic material, so that the efficiency in the insertion operation can be attained.

In the invention according to claim 2, a pressure sensitive layer, an outer electrode, and at least one lead-out wire provided with insulating coating are laminated and formed in a shape of a cable, wherein at a distal end portion either one of the central electrode and the outer electrode is connected to the lead-out wire. Therefore, in a case where, for example, the mechanical strength of the central electrode is greater than that of the outer electrode, only the outer electrode is connected to the lead-out wire at the distal end portion, and a resistor is connected between the central electrode and the and the lead-out wire which is electrically conductive with the outer electrode in the external circuit. Then, it becomes possible to detect a disconnection of the outer electrode and a short circuit between the outer electrode and the central electrode, so that it becomes possible to rationalize the lead-out wires disposed in the pressure sensitive sensor.

In the invention according to claim 3, the lead-out wires according to claim 1 or 2, in particular, are disposed in close contact with the central electrode. Therefore, if the insulating coating of the lead-out wire is removed at the distal end portion, conduction with the central electrode can be easily established, so that the efficiency in operation can be attained. Further, for example, when the pressure sensitive layer is molded around the central electrode by extrusion in the process of manufacturing the pressure sensitive sensor, it becomes possible to effect extrusion by bundling the lead-out wires with the central electrode, so that the time and trouble involved in separately disposing the lead-out wires becomes unnecessary, so that the efficiency at the time of molding can be attained.

In the invention according to claim 4, the lead-out wires according to claim 1 or 2, in particular, are disposed in close contact with the outer electrode. Therefore, if the insulating coating of the lead-out wire is removed at the distal end portion, conduction with the outer electrode can be easily established, so that the efficiency in operation can be attained.

In the invention according to claim 5, the lead-out wires according to any one of claims 1 to 4, in particular, have a characteristic that their mechanical strength is greater than that of at least one of the central electrode and the outer electrode. Therefore, the lead-out wires are not disconnected before the central electrode and the outer electrode are disconnected, so that erroneous detection of disconnection is nil, and the detection reliability improves.

In the invention according to claim 6, the pressure sensitive sensor according to any one of claims 1 to 5, in particular, further comprises: a protective portion for providing insulation protection for the distal end portion. Therefore, the end portion is provided with insulation protection, so that reliability improves.

In the invention according to claim 7, the pressure sensitive layer according to any one of claims 1 to 6, in particular, is formed of a piezoelectric material. Therefore, an output voltage corresponding to the acceleration of deformation of the pressure sensitive sensor due to, for instance, contact with an object, so that the contact with an object can be detected with higher sensitivity than an ordinary electrode contact-type pressure sensitive sensor.

### <Brief Description of the Drawings>

Fig. 1 is a schematic diagram of a pressure sensitive sensor in accordance with a first embodiment;
Fig. 2 is a cross-sectional view along line A - A in Fig. 1;
Fig. 3(a) is a cross-sectional view of the pressure sensitive sensor in an arrangement in which a central electrode is formed by a plurality of metal single conductors, which are bundled in a helical shape together with lead-out wires;
Fig. 3(b) is a cross-sectional view of the pressure sensitive sensor in an arrangement in which the lead-out wires are disposed on a periphery of a piezoelectric material layer;
Fig. 3(c) is a cross-sectional view of the pressure sensitive sensor in an arrangement in which the lead-out wires are disposed on a periphery of an outer electrode;
Fig. 4 is a schematic diagram of another example of an external circuit;
Fig. 5 is a schematic diagram of the pressure sensitive sensor in accordance with a second embodiment (a case where only the outer electrode is connected to the lead-out wire at a distal end portion);
Fig. 6 is a schematic diagram of the pressure sensitive sensor in accordance with the second embodiment (a case where only the inner electrode is connected to the lead-out wire at the distal end portion);
Fig. 7 is a schematic diagram of still another example of the external circuit;
Fig. 8 is a schematic diagram illustrating a terminal processing arrangement using an electrically conductive rubber cap in the pressure sensitive sensor in accordance with a third embodiment; and
Fig. 9 is a schematic diagram of a conventional pressure sensitive sensor.

In the drawings, reference numeral 1 denotes a pressure sensitive sensor; 2 denotes a central electrode; 3 denotes a piezoelectric material layer (pressure sensitive layer); 4 denotes an outer electrode; and 10, 11, and 18 denote lead-out wires.

### <Best Mode for Carrying Out the Invention>

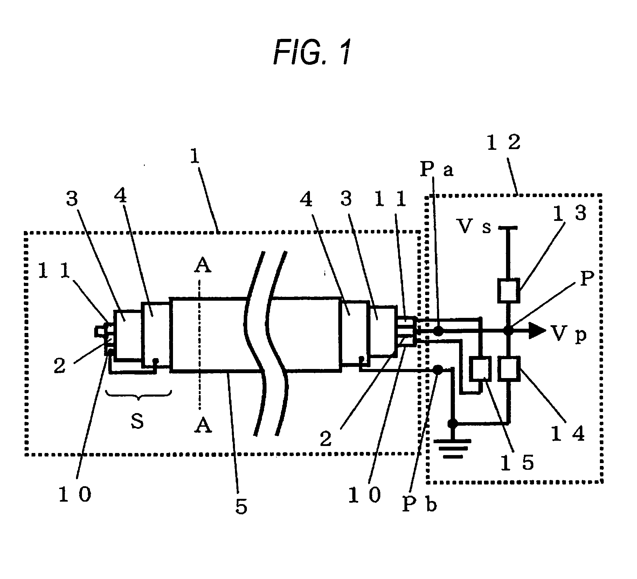

Referring now to Figs. 1 to 7, a description will be given of the embodiments of the present invention.

### (First Embodiment)

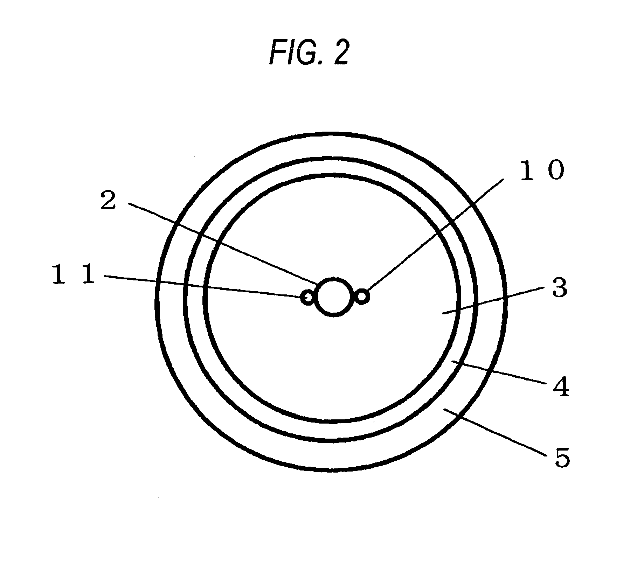

Referring to Figs. 1 and 2, a description will be given of a first embodiment of the invention.

Fig. 1 is a schematic diagram of a pressure sensitive sensor in accordance with the first embodiment. Fig. 2 is a cross-sectional view at the position of A - A in Fig. 1. In Fig. 1, a pressure sensitive sensor 1 is a piezoelectric sensor in which a central electrode 2, a piezoelectric material layer 3 serving as a pressure sensitive layer, an outer electrode 4, a cladding layer 5, and lead-out wires 10 and 11 provided with insulating coating are laminated and formed in the shape of a coaxial cable. As shown in Fig. 2, the lead-out wires 10 and 11 are disposed in close contact with the central electrode 2.

As the central electrode 2, it is possible to use an ordinary metal single conductor, but here an electrode is used in which a metal coil is wound around insulating high polymer fibers. The piezoelectric material layer 3 consists of a composite piezoelectric material in which a rubber elastic material is mixed with a sintered powder of a piezoelectric ceramic. As the rubber elastic material, chlorinated polyethylene, for example, is used. It should be noted that, as another construction of the piezoelectric material layer 3, it is possible to adopt a construction which uses a high polymer piezoelectric material such as polyvinylidene fluoride. As the outer electrode 4, it is possible to use a braided electrode, but here a strip electrode in which a metal film is adhered to a high polymer layer is used. In the case where the strip electrode is used, a construction is adopted in which this strip electrode is wound around the piezoelectric material layer 3, and in order to shield the pressure sensitive sensor 1 from electrical noise of the external environment, the strip electrode should preferably be wound around the piezoelectric material layer 3 in such a manner as to partially overlap with each other.

As the lead-out wires 10 and 11, electric wires provided with insulating coating, such as enameled wires, are used. In this case, it is desirable to select the thickness of the coating and the coating material so as to eliminate the contact and friction between the lead-out wires and between the lead-out wire and the inner electrode and the deterioration of the coating due to bending. Further, as the lead-out wires 10 and 11, those are selected which have a characteristic that their mechanical strength is greater than that of at least one of the central electrode 2 and the outer electrode 4.

As the cladding layer 5, it is sufficient to use vinyl chloride or polyethylene, but it is possible to use an elastic material such as rubber, whose pliability and flexibility are better than those of the piezoelectric material layer 3, e.g., ethylene propylene rubber (EPDM), chloroprene rubber (CR), butyl rubber (IIR), silicon rubber (Si), a thermoplastic elastomer, and the like, so that the pressure sensitive sensor can be easily deformed when it is pressed.

The pressure sensitive sensor 1 is manufactured by the following process. First, a chlorinated polyethylene sheet and a powder of a piezoelectric ceramic (here, lead zirconate titanate) of (40 to 70) vol.% are uniformly mixed into a sheet form by the roll process. After this sheet is finely cut into pellet form, these pellets are continuously extruded together with the central electrode 2 and the lead-out wires 10 and 11 to form the piezoelectric material layer 3. Subsequently, a dummy electrode is brought into contact with the outer side of the piezoelectric material layer 3, and a dc high voltage of (5 to 10) kV/mm is applied between the central electrode 2 and the dummy electrode to effect the polarization of the piezoelectric material layer 3. After the polarization, the outer electrode 4 is wound around the piezoelectric material layer 3. Finally, the cladding layer 5 is continuously extruded in such a manner as to surround the outer electrode 4. Since chlorinated polyethylene is used as the piezoelectric material layer 3, the vulcanization process which is required in the manufacture of general synthetic rubber is not required.

Next, as shown in Fig. 1, the cladding layer 5 is stripped by a predetermined length at a distal end portion S of the pressure sensitive sensor 1 to expose the outer electrode 4, the piezoelectric material layer 3, the lead-out wires 10 and 11, and the central electrode 2. Then, the lead-out wire 11 is connected to the central electrode 2, and the lead-out wire 10 is connected to the outer electrode 4. The connection is effected by soldering, spot welding, crimping, or the like. After this connection, the end portion S is hermetically sealed by a protective portion (not shown) constituted by a heat-shrinkable tube, resin, or the like for the sake of insulation protection. After the sealing, the end portion S is further covered, as required, by an electrically conductive member, and the outer electrode 4 and the electrically conductive member are brought into conduction to shield the end portion S. The pressure sensitive sensor 1 is manufactured by the above-described process.

In Fig. 1, reference numeral 12 denotes an external circuit connected to the pressure sensitive sensor 1. Reference numeral 13 denotes a first resistor for detection of a disconnection and a short circuit; 14, a second resistor for leading out a signal from the pressure sensitive sensor 1; and 15, a third resistor, the respective resistors having the same resistance values (R1, R2, and R3, respectively) as those of a circuit-side resistor 8, a signal leading-out resistor 9, and a sensor-side resistor 6 explained with respect to the conventional pressure sensitive sensor. It is assumed that the voltage at a point P is Vp, and that a supply voltage is Vs. Resistance values of several megaohms to several dozen megaohms are generally used as R1, R2, and R3.

With respect to the pressure sensitive sensor constructed as described above, a description will be given of its operation and action. In a case where the electrodes of the pressure sensitive sensor 1 are normal, Vp assumes a divided voltage value of R1 and the parallel resistance of R2 and R3 with respect to Vs. Here, since the resistance value of the piezoelectric material layer 3 is generally several hundred megaohms or more, the resistance value of the piezoelectric material layer 3 practically does not contribute to the parallel resistance value of R2 and R3, so that this resistance value is assumed to be negligible in the calculation of the aforementioned divided voltage value. Next, if at least one of the central electrode 2 and the outer electrode 4 of the pressure sensitive sensor 1 becomes disconnected, a point Pa or a point Pb becomes equivalently open, so that Vp assumes a divided voltage value of R1 and R2. If the central electrode 2 and the outer electrode 4 are short-circuited, the point Pa and the point Pb become equivalently short-circuited, so that Vp becomes equal to the circuit ground voltage. Thus, an abnormality such as a disconnection or a short circuit of the electrode of the pressure sensitive sensor 1 is detected on the basis of the value of Vp.

In addition, in the original use of the pressure sensitive sensor 1, if pressing pressure is applied to the pressure sensitive sensor 1 by contact with an object, for example, the pressure sensitive sensor 1 becomes deformed, so that a potential difference occurs between the central electrode 2 and the outer electrode 4 due to the piezoelectric effect, and Vp changes. By detecting such a change in Vp, an application such as the determination of the contact with an object becomes possible.

As described above, in this embodiment, the central electrode, the pressure sensitive layer, the outer electrode, and the plurality of lead-out wires provided with insulating coating are laminated and formed in the shape of a cable, at the distal end portion at least one of the lead-out wires is connected to the central electrode, and the remaining lead-out wire is connected to the outer electrode. Consequently, if, for example, the pressure sensitive sensor is connected to an external circuit, and a resistor is connected between the lead-out wire conducting with the central electrode and the lead-out wire conducting with the outer electrode in the external circuit instead of providing the resistor at the distal end portion of the pressure sensitive sensor in the conventional manner, a circuit is formed which is equivalent to the circuit for detecting a disconnection and a short circuit in the conventional pressure sensitive sensor, making it possible detect a disconnection and a short circuit of each electrode. In addition, since the resistor is not provided at the distal end portion in the conventional manner, the construction of the leading end portion becomes simple, and a nonsensitive area can also be reduced, so that the detection performance improves. Further, since the outside diameter of the distal end portion can be made small, it becomes easy to insert the pressure sensitive sensor when the pressure sensitive sensor is inserted into an elastic material, so that the efficiency in the insertion operation can be attained.

In addition, by disposing the lead-out wires in close contact with the central electrode, if the insulating coating of the lead-out wire is removed at the distal end portion, conduction with the central electrode can be easily established, so that the efficiency in operation can be attained. Further, for example, when the pressure sensitive layer is molded around the central electrode by extrusion in the process of manufacturing the pressure sensitive sensor, it becomes possible to effect extrusion by bundling the lead-out wires with the central electrode, so that the time and trouble involved in separately disposing the lead-out wires becomes unnecessary, so that the efficiency at the time of molding can be attained.

In addition, since the lead-out wires have the characteristic that their mechanical strength is greater than that of either one of the central electrode and the outer electrode, the lead-out wires are not disconnected before the central electrode and the outer electrode are disconnected, so that erroneous detection of disconnection is nil, and the detection reliability improves.

In addition, since the protective portion for providing insulation protection for the distal end portion is provided, the end portion is provided with insulation protection, so that reliability improves.

In addition, since the pressure sensitive layer is formed of a piezoelectric material, an output voltage corresponding to the acceleration of deformation of the pressure sensitive sensor due to, for instance, contact with an object, so that the contact with an object can be detected with higher sensitivity than an ordinary electrode contact-type pressure sensitive sensor.

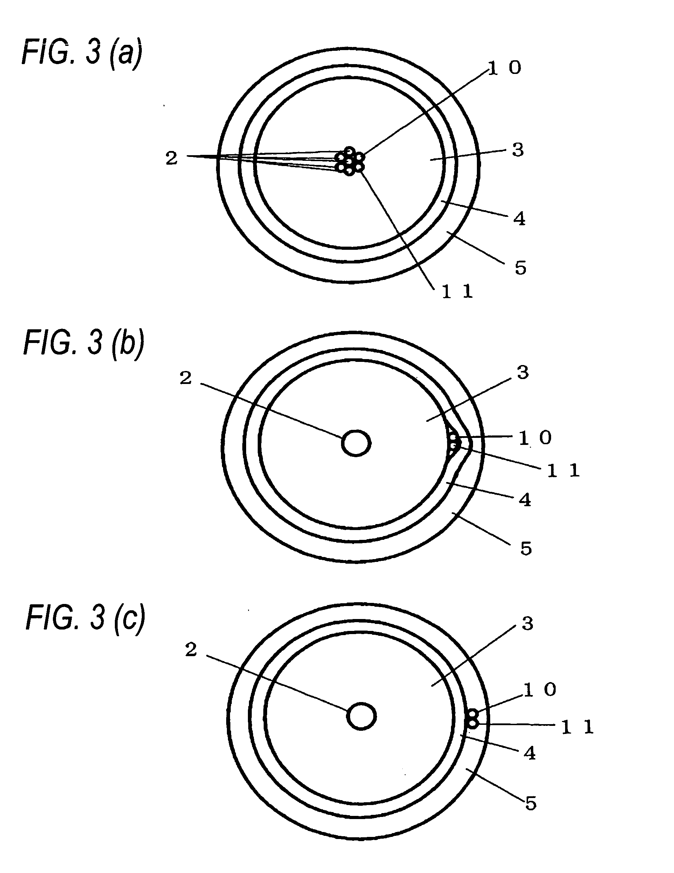

It should be noted that although in this embodiment the lead-out wires are disposed in close contact with the central electrode, the arrangement of disposition of the lead-out wires is not limited to the same, and another arrangement may be used. Another arrangement of disposition of the lead-out wires is shown in Figs. 3(a) to 3(c). Fig. 3(a) shows an arrangement in which the central electrode 2 is formed by a plurality of metal single conductors, which are bundled in a helical shape together with the lead-out wires 10 and 11. Fig. 3 (b) shows an arrangement in which the lead-out wires 10 and 11 are disposed on the periphery of the piezoelectric material layer 3. Fig. 3(c) shows an arrangement in which the lead-out wires 10 and 11 are disposed on the periphery of the outer electrode 4. By using these arrangements, advantages similar to those of the first embodiment are obtained. In addition, in the arrangements of Figs. 3(b) and 3(c), in particular, the construction provided is such that the lead-out wires are disposed in close contact with the outer electrode 4, and by virtue of this construction, if the insulating coating of the lead-out wire 10 is removed at the distal end portion, conduction with the outer electrode 4 can be easily established, so that the efficiency in operation can be attained.

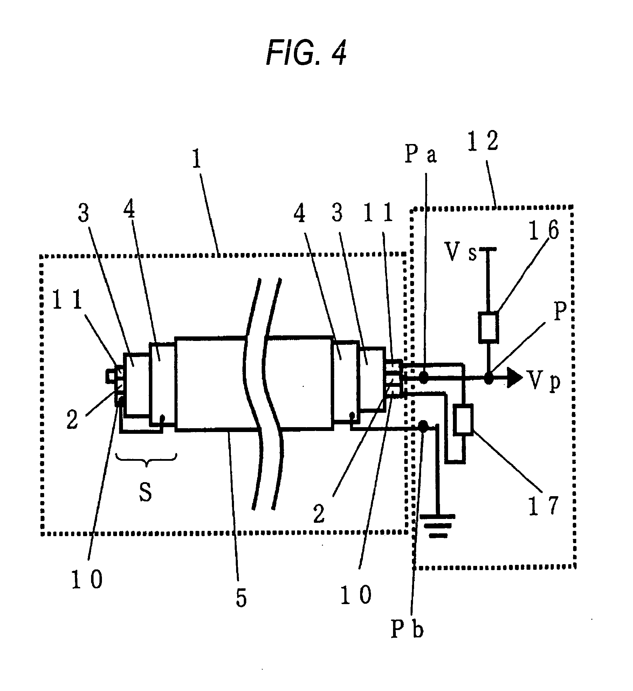

In addition, as another example of the external circuit 12, the second resistor 14 in Fig. 1 may be eliminated, and a configuration may be provided such that, as shown in Fig. 4, the supply voltage Vs is divided by a fourth resistor 16 (resistance value R4) and a fifth resistor 17 (resistance value R5), and a signal from the pressure sensitive sensor 1 is led out. By virtue of this configuration, in a case where the electrodes of the pressure sensitive sensor 1 are normal, Vp assumes a divided voltage value of R4 and R5 with respect to Vs. Here, since the resistance value of the piezoelectric material layer 3 is generally several hundred megaohms or more, the resistance value of the piezoelectric material layer 3 practically does not contribute to R5, so that this resistance value is assumed to be negligible in the calculation of the aforementioned divided voltage value. Next, if at least one of the central electrode 2 and the outer electrode 4 of the pressure sensitive sensor 1 becomes disconnected, the point Pa or the point Pb becomes equivalently open, so that Vp becomes equal to Vs. If the central electrode 2 and the outer electrode 4 are short-circuited, the point Pa and the point Pb become equivalently short-circuited, so that Vp becomes equal to the circuit ground voltage. Thus, an abnormality such as a disconnection or a short circuit of the electrode of the pressure sensitive sensor 1 is detected on the basis of the value of Vp.

### (Second Embodiment)

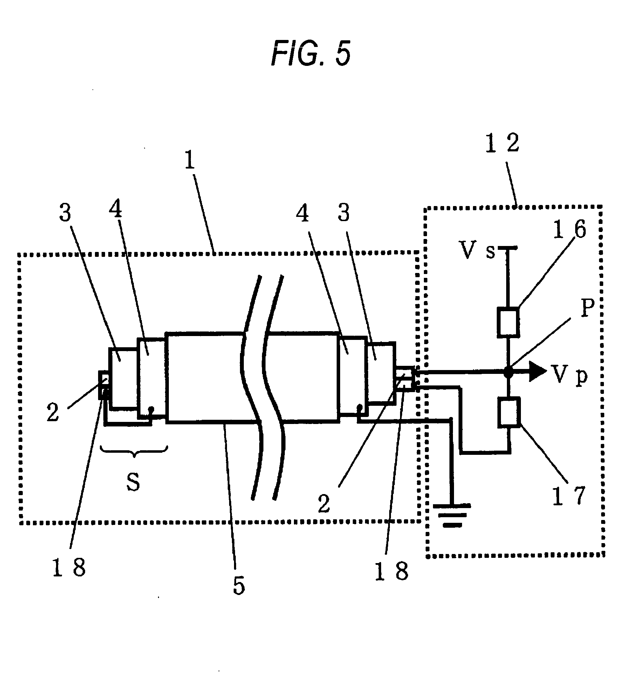

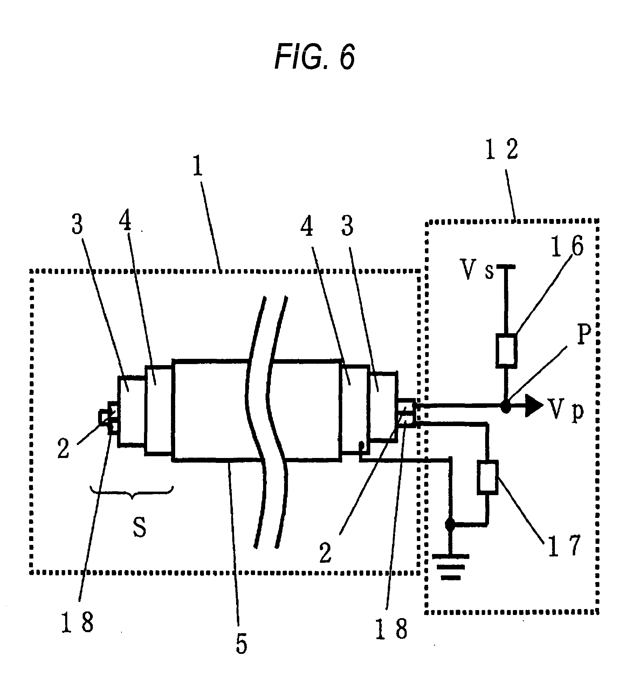

Referring to Figs. 5 and 6, a description will be given of the invention in accordance with a second embodiment. Figs. 5 and 6 are schematic diagrams of the pressure sensitive sensor 1 in accordance with this embodiment. This embodiment differs from the first embodiment in that a lead-out wire 18 is connected to either one of the central electrode 2 and the outer electrode 4 at the distal end portion S. Here, Fig. 5 is a schematic diagram in the case where the lead-out wire 18 is connected to the outer electrode 4 at the distal end portion, and Fig. 6 is a schematic diagram in the case where the lead-out wire 18 is connected to the central electrode 2 at the distal end portion.

By virtue of the above-described configuration, since either one of the central electrode 2 and the outer electrode 4 is connected to the lead-out wire 18 at the distal end portion S, in a case where, for example, the mechanical strength of the central electrode 2 is greater than that of the outer electrode 4, only the outer electrode 4 is connected to the lead-out wire 18 at the distal end portion S, and the fifth resistor 17 is connected between the lead-out wire 18 and the central electrode 2 in the external circuit, as shown in Fig. 5. Then, if the pressure sensitive sensor 1 is normal, Vp changes due to the deformation of the pressure sensitive sensor 1 by using as a reference value a voltage value obtained by dividing Vs by R4 and R5. Meanwhile, if there is a disconnection of the outer electrode 4, Vp becomes equal to Vs, and if there is a short circuit between the outer electrode 4 and the central electrode 2, Vp becomes equal to the circuit ground voltage. Thus, it becomes possible to detect the disconnection of the outer electrode 4 and a short circuit between the outer electrode 4 and the central electrode 2 on the basis of the value of Vp.

On the other hand, in a case where the mechanical strength of the outer electrode 4 is greater than that of the central electrode 2, only the central electrode 2 is connected to the lead-out wire 18 at the distal end portion S, and the fifth resistor 17 is connected between the lead-out wire 18 and the outer electrode 4 in the external circuit, as shown in Fig. 6. Then, if the pressure sensitive sensor 1 is normal, Vp changes due to the deformation of the pressure sensitive sensor 1 by using as a reference value a voltage value obtained by dividing Vs by R4 and R5. Meanwhile, if there is a disconnection of the central electrode 2, Vp becomes equal to Vs, and if there is a short circuit between the central electrode 2 and the outer electrode 4, Vp becomes equal to the circuit ground voltage.

In addition, in the original use of the pressure sensitive sensor 1, if pressing pressure is applied to the pressure sensitive sensor 1 by contact with an object, for example, the pressure sensitive sensor 1 becomes deformed, so that a potential difference occurs between the central electrode 2 and the outer electrode 4 due to the piezoelectric effect, and Vp changes. By detecting such a change in Vp, an application such as the determination of the contact with an object becomes possible.

Since either one of the central electrode and the outer electrode is connected to the lead-out wire at the distal end portion, as described above, in a case where, for example, the mechanical strength of the central electrode is greater than that of the outer electrode, only the outer electrode is connected to the lead-out wire at the distal end portion, and a resistor is connected between the central electrode and the and the lead-out wire which is electrically conductive with the outer electrode in the external circuit. Then, it becomes possible to detect a disconnection of the outer electrode and a short circuit between the outer electrode and the central electrode, so that it becomes possible to rationalize the configuration by reducing the number of lead-out wires more than in the configuration of the first embodiment.

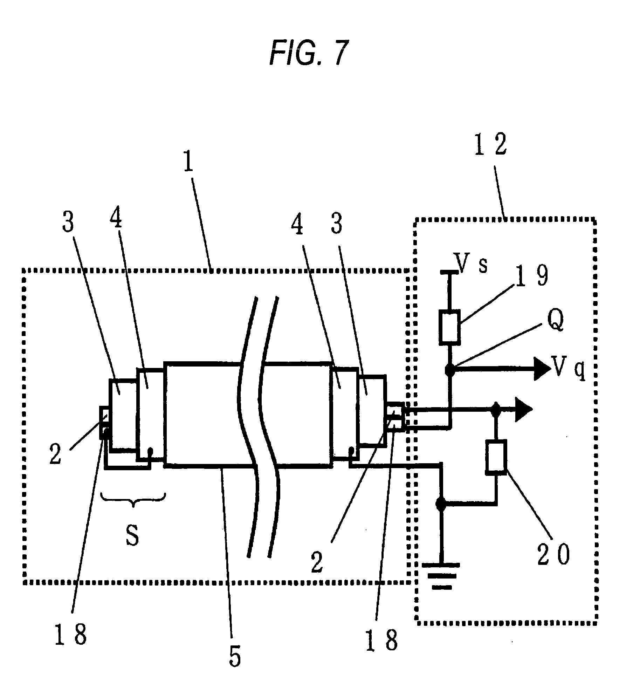

It should be noted that as another example of the external circuit 12 in the configuration of Fig. 5, it is possible to adopt a configuration in which, as shown in Fig. 7, a sixth resistor 19 is connected between the lead-out wire 18 and the supply voltage Vs, and a seventh resistor 20 for leading out a signal from the pressure sensitive sensor 1 is disposed between the central electrode 2 and the outer electrode 4. By virtue of the configuration described above, if the pressure sensitive sensor 1 is normal, a voltage Vq at a point Q becomes equal to the circuit ground voltage, and if there is a disconnection of the outer electrode 4, Vq becomes equal to Vs. In addition, resistance values of several megaohms to several dozen megaohms are generally used as the first to fifth resistors and the seventh resistor in the above-described first and second embodiments, the resistance value of the sixth resistor 19 may be several kiloohms to several dozen kiloohms, so that the effect of noise is unlikely to be received.

### (Third Embodiment)

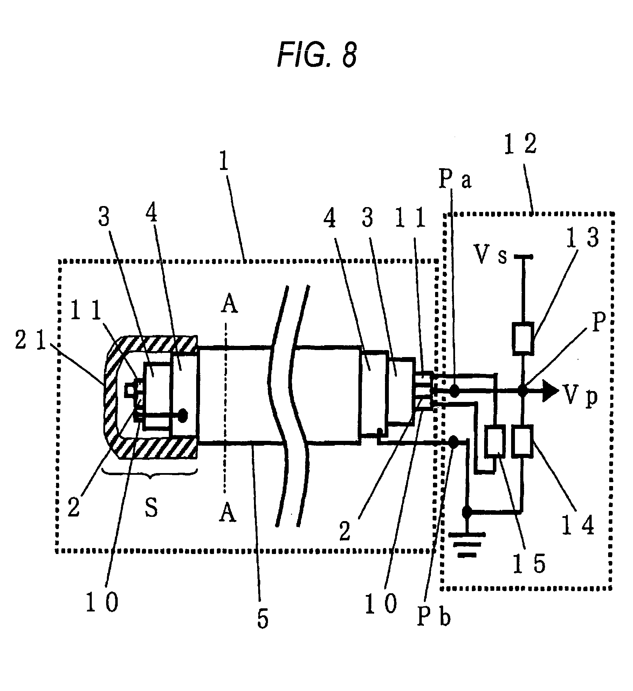

Referring to Fig. 8, a description will be given of a third embodiment concerning the processing of a terminal in accordance with the invention.

In the first embodiment shown in Fig. 1, it has already been described that the distal end portion S is hermetically sealed by a protective portion (not shown) constituted by a heat-shrinkable tube, resin, or the like for the sake of insulation protection, the distal end portion S is subsequently further covered, as required, by an electrically conductive member, and the outer electrode 4 and the electrically conductive member are brought into conduction to shield the end portion S.

This embodiment is particularly characterized in that the distal end portion S of the first embodiment is covered by an electrically conductive rubber cap 21. A heat-shrinkable conductive rubber cap, for instance, is used, and the inside diameter of the electrically conductive rubber cap 21 is set to be slightly smaller than the outside diameter of the outer electrode 4. As a result, after the shrinkage, the electrically conductive rubber cap 21 is not only mechanically engaged with the outer electrode 4, but is made electrically conductive therewith. By virtue of a simple configuration, it is possible to attain the mechanical protection and an electrical seal for the terminal.

If, in the conventional manner, after the resistor for detecting a disconnection is connected to the distal end portion S, the heat-shrinkable conductive rubber cap is fitted to this distal end portion S, then the conductive rubber cap must be made large (long) by the portion of a disconnection detecting resistor body and its both terminal portions. Accordingly, the distal end portion S can possibly be bent or broken during the insertion or the operation, which causes the outer electrode and a terminal portion of the disconnection detecting resistor to contact each other, so that heed has been paid to handling. However, by using this configuration, the electrodes such as the central electrode can be made extremely short, so that the insulation of the distal end portion S has been facilitated.

In addition, although a configuration has been illustrated in which a gap is provided between each electrode and the electrically conductive rubber in the electrically conductive rubber cap 21 to secure an insulation distance, it goes without saying that an insulating material is injected to the cavity in the electrically conductive rubber cap 21 to further improve insulating properties.

In addition, although in the foregoing embodiments, as the lead-out wires, electric wires provided with insulating coating, such as enameled wires, are used, the construction of the lead-out wires is not limited to the same. For example, it is possible to use other electric wires, such as general electric wires provided with insulating coating, and strip electrodes provided with insulating coating on their surfaces.

### <Industrial Applicability>

As is apparent from the foregoing embodiments, according to the pressure sensitive sensor of the invention, if, for example, the pressure sensitive sensor is connected to an external circuit, and a resistor is connected between the lead-out wire conducting with the central electrode and the lead-out wire conducting with the outer electrode in the external circuit instead of providing the resistor at the distal end portion of the pressure sensitive sensor in the conventional manner, a circuit is formed which is equivalent to the circuit for detecting a disconnection and a short circuit in the conventional pressure sensitive sensor, making it possible detect a disconnection and a short circuit of each electrode. In addition, since the resistor is not provided at the distal end portion in the conventional manner, the construction of the leading end portion becomes simple, and a nonsensitive area can also be reduced, so that the detection performance improves. Further, since the outside diameter of the distal end portion can be made small, it becomes easy to insert the pressure sensitive sensor when the pressure sensitive sensor is inserted into an elastic material, so that the efficiency in the insertion operation can be attained.

## Claims

1. A pressure sensitive sensor comprising:
a central electrode;
a pressure sensitive layer;
an outer electrode; and
a plurality of lead-out wires provided with insulating coating being laminated and formed in a shape of a cable,
wherein at a distal end portion at least one of the lead-out wires is connected to the central electrode, and a remaining lead-out wire is connected to the outer electrode.

2. A pressure sensitive sensor comprising:
a central electrode;
a pressure sensitive layer;
an outer electrode; and
at least one lead-out wire provided with insulating coating being laminated and formed in a shape of a cable,
wherein at a distal end portion either one of the central electrode and the outer electrode is connected to the lead-out wire.

3. The pressure sensitive sensor according to claim 1, wherein the lead-out wires are disposed in close contact with the central electrode.

4. The pressure sensitive sensor according to claim 1, wherein the lead-out wires are disposed in close contact with the outer electrode.

5. The pressure sensitive sensor according to any one of claims 1 to 4, wherein the lead-out wires have a characteristic that their mechanical strength is greater than that of at least one of the central electrode and the outer electrode.

6. The pressure sensitive sensor according to any one of claims 1 to 5, further comprising: a protective portion for providing insulation protection for the distal end portion.

7. The pressure sensitive sensor according to any one of claims 1 to 6, wherein the pressure sensitive layer is formed of a piezoelectric material.
